Europäisches Patentamt

European Patent Office

Office européen des brevets

(19)

(11) Publication number: **0 032 018**
**B1**

# EUROPEAN PATENT SPECIFICATION

(45) Date of publication of patent specification: **17.08.83**

(51) Int. Cl.³: **H 01 L 27/02, H 01 L 27/06**

(21) Application number: **80304549.1**

(22) Date of filing: **17.12.80**

(54) Semiconductor integrated circuit device.

(30) Priority: **24.12.79 JP 167825/79**

(43) Date of publication of application:
**15.07.81 Bulletin 81/28**

(45) Publication of the grant of the patent:
**17.08.83 Bulletin 83/33**

(84) Designated Contracting States:
**DE FR GB NL**

(56) References cited:
**JP - A - 53 072 472**
**US - A - 3 757 145**

**IBM TECHNICAL DISCLOSURE BULLETIN, vol.
13, no. 9, February 1971, New York, USA
C. D. BOSS et al. "Series N-channel MOSFET
gate protection circuit", page 2800**

**IBM TECHNICAL DISCLOSURE BULLETIN, vol.
13, no. 5, October 1970, New York, USA
W. FISCHER et al. "Resistor-thick oxide FET
gate protection device for thin oxide FET",
pages 1272—1273**

(73) Proprietor: **FUJITSU LIMITED**
**1015, Kamikodanaka Nakahara-ku
Kawasaki-shi Kanagawa 211 (JP)**

(72) Inventor: **Sasaki, Nobuo**
**1-14-240, Kawara-cho Saiwai-ku
Kawasaki-shi Kanagawa 210 (JP)**

(74) Representative: **Sunderland, James Harry et al,
HASELTINE LAKE & CO Hazlitt House 28
Southampton Buildings Chancery Lane
London WC2A 1AT (GB)**

Courier Press, Leamington Spa, England

## Semiconductor integrated circuit device

This invention relates to a semiconductor integrated circuit (IC) device.

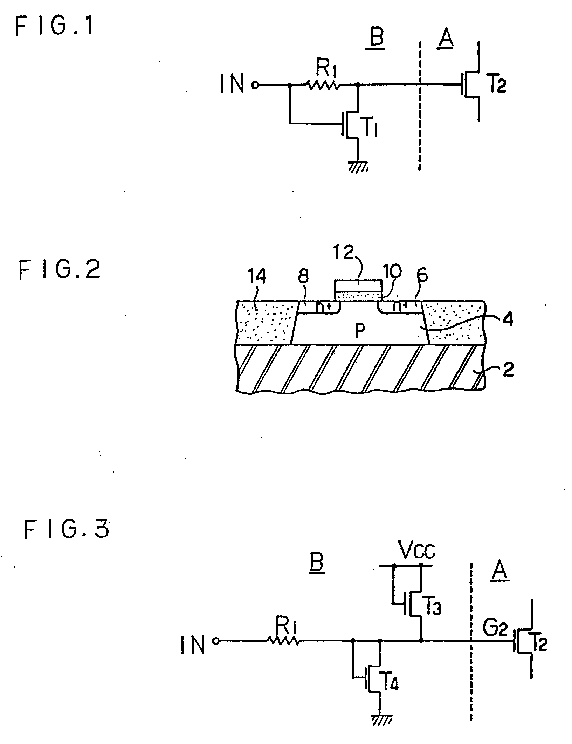

It is general practice when fabricating a metal-oxide-semiconductor (MOS) IC having a silicon substrate to provide a protective circuit B, as shown in Figure 1 of the accompanying drawings, which is a schematic circuit diagram, in order to prevent any excessively high voltage applied accidentally to an input terminal IN from being applied to an input gate of an MOS transistor T2 of an internal circuit A of the IC. Such a protective circuit is provided because the insulation layer, for example a silicon dioxide layer, in series with the gate in transistor T2 is very thin, so that if too large a voltage applied to the input terminal IN, as can occur as a result of an electrostatic discharge during handling on a dry day, were applied directly to the transistor T2 the oxide layer would rupture owing to excessive electrostatic field stress. In order to prevent this, protective circuit B is provided of a resistor R1 of a resistance value of the order of 1 kΩ connected in series between input terminal IN and the gate of T2 and a transistor T1 for protective purposes connected between the gate of transistor T2 and ground. Transistor T1 is fabricated as one MOS transistor, but a field oxide layer of a thickness of approximately 7000Å is used as the gate insulating layer for that transistor T1 and its gate is fabricated of an aluminium layer, even for silicon gate MOS IC's (i.e. IC's in which the gates of all internal circuit transistors are of silicon (polycrystal silicon)). Thus, the threshold voltage of the protective transistor T1 is approximately ten times larger than that of the internal transistor T2 of which the threshold voltage is usually about 0.8 V. Under normal operating conditions, transistor T1 is OFF, but if an abnormal voltage is applied to the input terminal IN, T1 turns ON, causing a voltage drop at resistor R1 and allowing charges to be passed to ground. This maintains the voltage at the gate of transistor T2 at a low value and protects the transistor T2. In other words, input voltage at terminal IN does not go directly to transistor T2, but by virtue of resistor R1 enters transistor T1 first.

It has been proposed to replace transistor T1 of Figure 1 with a diode. For convenience, we shall consider an N-channel type MOS IC. When a negative voltage is applied, the diode allows current to flow to ground. When a positive voltage is applied which is higher than the breakdown voltage of the MOS device, current is also allowed to flow to ground. However, such a diode does not perform as effectively as the transistor T1 of Figure 1.

With an SOS IC as shown in Figure 2, a silicon semiconductor layer is grown on an insulating sapphire substrate 2, and a field oxide layer surrounding an active region of the silicon semiconductor layer, i.e. a region where active device elements are to be fabricated, is etched away, or partially removed by etching and oxidised to form insulating layer 14 of silicon dioxide to define and confine the active region in a silicon island 4. A transistor is provided by means of gate insulating layer 10 and a gate electrode 12 of polycrystalline silicon fabricated centrally on the silicon island 4. Employing electrode 12 as a mask, source and drain regions 6 and 8 are formed by diffusion of impurities or by ion implantation of impurities, and thus an MOS transistor is formed. There is in practice no problem in using this MOS transistor as a transistor T2 of the internal circuit A of Figure 1. However, it is not suitable for use as transistor T1 of the protective circuit B because the gate insulating layer 10 is thin and has a low withstand or breakdown voltage, so that the layer 10 itself would be likely to be ruptured. Thus, it is desired, as in the case of a bulk MOS IC, to utilize thick field oxide layer 14 surrounding the silicon island 4 in the formation of a transistor to function as transistor T1 of Figure 1. However, in an SOS structure, there is an insulating substrate 2, and not a silicon semiconductor substrate, immediately below the field oxide layer 14, so that fabrication of such a transistor utilizing the field oxide layer 14 cannot be realized.

A circuit such as circuit B shown in Figure 3 of the accompanying drawings, which is a schematic circuit diagram, is in use as a protective circuit in SOS MOS IC's. This circuit is in use because the field oxide layer 14 cannot be used for the gate oxide layer for a transistor T1 as shown in Figure 1, and it is difficult to provide a thick gate oxide layer especially for a protective transistor such as transistor T1 of Figure 1 when thin gate oxide layers are employed in transistors in internal circuits. The protective circuit of Figure 3 contains, in addition to a serial resistor R1, two silicon gate MOS transistors T3, T4 (both p-channel type transistors). Transistor T3 is connected between gate G2 of transistor T2 (a transistor of an internal circuit of the IC) and a positive power source Vcc, and transistor T4 is connected between the gate G2 and ground. The gate G2 is connected through resistor R1 to input terminal IN. The gate of transistor T3 is connected to Vcc, and the gate of transistor T4 is connected to the gate G2. Therefore, under normal conditions, that is, when a voltage Vi applied to the input terminal IN is equal to the level existing between the power source Vcc and ground, both transistors T3 and T4 are OFF. When voltage Vi applied to the input terminal IN takes a value such that

$$Vi \gg Vcc > 0 \text{ or } Vi \ll 0,$$

or, more particularly, when Vi exceeds the value

$$Vcc + Vth3$$

where Vth3 is the threshold voltage of transistor T3, the transistor T3 turns ON to pass current from the input terminal IN to the power source Vcc, and when the input voltage Vi falls below — |Vth4| (Vth4 being the threshold voltage of the transistor T4), the transistor T4 turns ON and causes current from the input terminal IN to flow to ground.

Transistors T3 and T4 can, alternatively, be N-channel type transistors, in which case the gate of transistor T3 is connected to the gate G2, and the gate of transistor T4 is connected to ground.

The gate of transistor T2 of the internal circuit A is thus protected.

However, the gate insulating layers of transistors T3 and T4 are as thin as that of transistor T2, so that when an excessively high voltage is applied to the input terminal IN, the insulation between the drain and the gate of either transistor T3 or T4 is very likely to be ruptured.

According to the present invention there is provided a semiconductor integrated circuit device having an element to be protected, characterised in that the device comprises a first resistive element interposed between an input terminal and the element to be protected, an insulated gate type transistor of which one of the drain and source regions is connected to the element to be protected, and the other of the drain and source regions is connected to a ground line (a line which is grounded when the device is in use), a capacitor interposed between the gate electrode of the insulated gate type transistor and the input terminal, and a second resistive element interposed between the gate of insulated gate type transistor and a ground line.

An embodiment of the present invention can provide a protective circuit for guarding an insulated gate transistor at an input of an internal circuit of a semiconductor integrated circuit against high voltages.

A semiconductor integrated circuit device embodying this invention has a first resistor interposed between an input terminal and an input gate of an element to be protected, an MIS type transistor of which the drain or the source is connected to the input gate of the element to be protected and of which the source or the drain is connected to ground, a capacitor interposed between the gate of the MIS type transistor and the input terminal, and a second resistor of a reverse biased diode placed between the gate of the MIS transistor and ground.

An embodiment of the present invention can overcome the problems experienced with SOS structure devices in which field oxide cannot be utilized (as a thick gate insulating layer), and can provide that fabrication of a protective transistor does not complicate processes for the manufacture of such a protective transistor.

In a semiconductor integrated circuit device embodying the present invention formed with elements of SOS structure and comprising an internal circuit and a protective circuit for guarding an insulated gate type transistor at an input to the internal circuit against high voltage, a transistor of the protective circuit, which is formed in the same manner as an insulated gate transistor in the internal circuit to be protected, has its gate grounded through a resistor or a reverse biased diode, a metal electrode is provided on the gate and is capacitively coupled therewith via an insulation layer between that gate and the metal electrode, and input signals are arranged to be applied to the metal electrode, either source or drain of the protective transistor is grounded, and input signals are arranged simultaneously to be applied through a further resistor to either to drain or source of the protective transistor and to the input gate of the insulated gate transistor at the input of the internal circuit.

Reference is made, by way of example, to the accompanying drawings, in which:—

Figure 1 is a schematic circuit diagram illustrating a prior art protective circuit for an MOS IC having a silicon substrate;

Figure 2 is a cross-sectional view of a prior art MOS transistor on an SOS IC;

Figure 3 is a schematic circuit diagram of a prior art protective circuit for an SOS IC;

Figures 4A, 4B and 4C are, respectively, an equivalent circuit diagram, a cross-sectional view and a plan view of an embodiment of this invention; and

Figures 5A and 5B are, respectively, an equivalent circuit diagram and a cross-sectional view of principal parts of another embodiment of this invention.

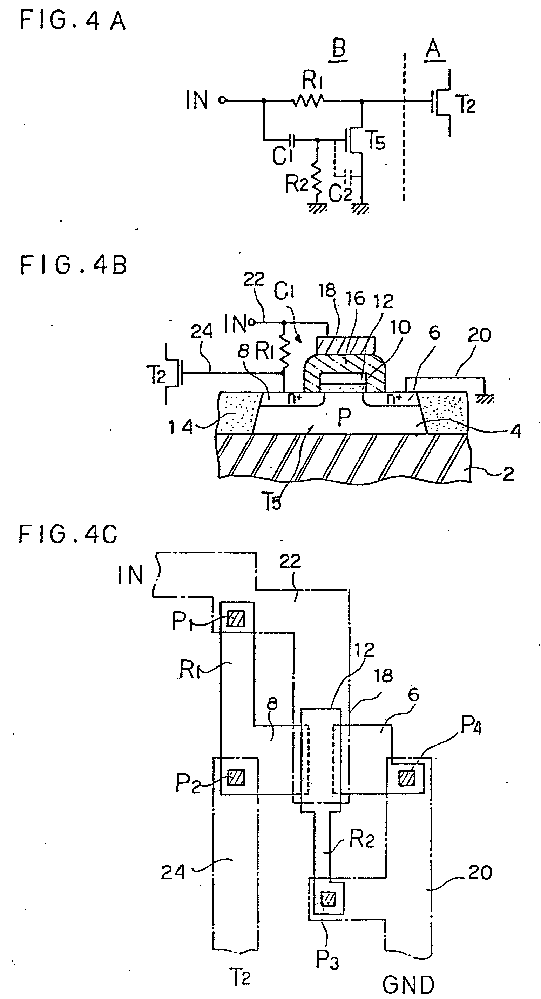

A transistor T5 of Figure 4A is an enhancement mode silicon gate MOS transistor fabricated by the same processes whereby a transistor T2 of an internal circuit A is formed. The gate insulating layer of the transistor T5 is not prepared to a particular extra thickness. The gate of transistor T5, grounded via a resistor R2 having a resistance value of about 1 MΩ, is connected to an input terminal IN through a capacitor C1. By means of such a structure, transistor T5 is provided with the same function as that of transistor T1 in Figure 1.

More particularly, transistor T5 is provided with a thin insulating oxide layer like that of transistor T2. However, by virtue of capacitor C1, an input signal applied to input terminal IN is not directly applied to the gate of transistor T5. Where the withstand or breakdown voltage of the capacitor C1 is positively high, an excessively high voltage applied to the input terminal IN is not directly applied to the oxide layer of the gate of transistor T5. That is to say, transistor T5 is turned ON without rupture of its gate, and causes current to flow to ground.

Resistor R2 performs an important role. There is a gate of transistor T5 in a region between the transistor T5 and the capacitor C1. If resistor R2 were not provided, the gate region of transistor T5 would float. It is not possible to predict what potential a floating region will have, and if charges are injected to such a floating region from other regions, the floating region is charged up. This would mean that, in the absence of resistor R2, transistor T5 might unexpectedly turn ON, and an input signal might not then be transmitted to transistor T2. To prevent this, resistor R2 having a high value of resistance is provided.

When high voltage noise such as an electrostatic discharge is applied to input terminal IN, transistor T5 thus turns ON, and causes electric charge to be passed to ground. Because the duration of such high voltage noise is short, in respect of such noise resistor R2 effectively does not exist. That is, resistor R2 can, approximately, be said not to be present.

Under normal operating conditions, the gate of transistor T5 is kept grounded by resistor R2. A normal signal input of 5 V, for example, passes through capacitor C1 to transistor T5. However, since there is a voltage drop at C1, the signal cannot turn transistor T5 ON. Thus, transistor T5 remains OFF when normal input signals are being applied, such signals being allowed to pass to transistor T2 alone. In short, where there is applied an excessively high voltage at input terminal IN, transistor T5 is turned ON to cause electric charge to be passed to ground.

If a negative high voltage is applied to the terminal IN shown in Figures 4, transistor T5 also turns ON and negative charge is swept away through the transistor T5, providing for protection of transistor T2; the voltage of heavily doped region 8 in Figure 4B is lower than that of heavily doped region 6 and the region 8 operates as source and the gate to source voltage becomes high enough to turn the transistor T5 ON because of the voltage drop at capacitor C1.

Since the gate of transistor T5 is thus connected through resistor R2, transistor T5 is OFF in a normal state, but when a high voltage is applied to input terminal IN, the voltage is divided between capacitors C1 and C2, where C2 is a parasitic capacitance effective between the gate of transistor T5 and ground and is illustrated by broken lines in Figure 4A, and so forth then applied to the gate of transistor T5 to turn it ON. The value of an excessive input voltage that will turn ON transistor T5 is determined by the ratio of voltage division provided by C1, C2, and by the threshold voltage of transistor T5. Therefore, these elements are selected accordingly. When transistor T5 is turned ON, voltage which would otherwise be applied to the gate of transistor T2 of the internal circuit A is led to ground via resistor R1 and transistor T5. As a result, the gate of transistor T2 is protected, and since the voltage drop through the gate insulating layer 10 (Figure 4B) of transistor T5 is small, transistor T5 is also safe from rupture of its gate insulating layer.

A specific structure providing circuitry as shown in Figure 4A is illustrated in Figure 4B and 4C. As will be understood from Figure 4B, the cross-sectional structure of transistor T5 is similar to the cross-sectional structure shown in Figure 2, except that an insulating layer 16 of phospho-silicate glass (PSG) is grown on silicon gate electrode 12, with an aluminium electrode 18 formed on the PSG layer 16. PSG layers are generally used in the art as insulation layers beneath aluminium wirings in the manufacture of integrated circuits, but the PSG layer 16 is employed in the embodiment illustrated in Figure 4B as a dielectric. Aluminium electrode 18 is a part of aluminium wiring, and capacitor C1 is provided between the electrode 18 and the gate electrode 12. A heavily doped region 6, for example a source region, of transistor T5 is grounded by aluminium wiring 20, and heavily doped region 8, for example a drain region, is connected to input terminal IN by aluminium wiring 22 via resistor R1 and to the gate of transistor T2 of the internal circuit by aluminium wiring 24. The gate of transistor T5 is grounded through resistor R2, but this is not shown in Figure 4B. Figure 4C illustrates the structure of Figure 4B in plan view. In Figure 4C resistor R1 is a diffused resistor connecting to drain region 8, the ends P1, P2 of the resistor R1 being in contact with wirings 22, 24. Resistor R2 is formed of polycrystalline silicon extending from one end of polycrystalline silicon gate 12, the other end of resistor R2 being in contact with wiring 20 at a point P3. Aluminium electrode 18 has one end above gate electrode 12. In Figure 4C, P4 is a location at which source region 6 and wiring 20 are in contact. In Figure 4C gate oxide layer 10 and PSG layer 16 are omitted.

It will be understood that although a sapphire substrate 2 is employed in the fabrication of the device shown in Figure 4A other insulating material such as spinel, bulk silicon or semi-insulating material such as chromium doped GaAs can be used instead of sapphire to provide a substrate. A protective circuit fabricated on insulating material, bulk silicon, or semi-insulating material and embodying the present invention functions as effectively as a protective circuit fabricated on sapphire.

It should be noted that, although silicon gate MOS transistors are used in Figure 4A as transistors T2 and T5, other self-aligned MOS transistors such as molybdenum (Mo) gate MOS transistors, molybdenum-silicide ($MoSi_2$) gate MOS transistors or tungsten (W) gate MOS transistors can be used. Going back to Figure 4B, it may be considered that, by eliminating gate electrode 12, a transistor with a thick gate insulating layer provided by PSG layer 16 can be formed which is similar to a protective transistor having a high value threshold voltage as shown in Figure 1 which utilises the field oxide layer. It has been found, however, that the threshold voltage of such a transistor is very unstable because of charges in the PSG layer 16.

It is to be noted further that diffusion of source and drain regions in the abovedescribed embodiment of the present invention were realised in a self-alignment fashion using the gate electrode as a mask in a usual silicon gate process, so that should electrode 12 be eliminated, diffusion of source and drain would not be possible in the usual way. This is not in line with established processes for the manufacture of silicon gate MOS IC's. A protective transistor of the "stacked gate" type as shown in Figure 4B has elements such as silicon island 4, source region 6 and drain region 8, gate insulation layer 10 and silicon gate electrode 12, all of which are fabricated by the same processes as are used to make the transistor of the internal circuit. The growth of PSG layers is known for the purposes of insulation of wirings, and electrode 18 is a wiring part. Thus, the fabrication of the device shown in Figure 4B can be realised without disruption of established processes for the manufacture of silicon gate MOS IC's.

In the embodiment of Figure 4B, the thickness of the PSG layer 16 is about 8000Å, and that of gate insulating oxide (silicon dioxide) layer 10 is about 500Å, and the values of resistors R1 and R2 are in the ranges of 1 kΩ and 1 MΩ respectively. The resistance of resistor R1 is so determined that it is high enough to protect the gate of transistor T2, but not so high as to cause delay in the transmission of signals.

In the embodiment of Figures 4, a polycrystalline silicon layer having a desired pattern is formed on the silicon island 4 and on insulating layer 14 to form the gate electrode of transistor T5 and resistor R2.

Then, impurity with low dosage is introduced into the polycrystalline silicon layer for adjusting the resistivity for the resistor R2.

Next, the portion of the polycrystalline silicon layer to be used for resistor R2 is covered by photoresist. Then, impurity of the same conductivity type is introduced with high dosage into the portions of the polycrystalline silicon layer used for the gate electrode of transistor T5, the contact portion P3 and the silicon island. Thereby, that portion of the polycrystalline silicon layer used for the resistor R2 has a high resistance and that portion of the polycrystalline silicon layer used for the gate electrode of transistor T5 and for the contact portion P3 has a low resistance.

Heavily doped regions 6 and 8 are formed by a second ion implantation. The resistor R1 may also be formed by the second ion implantation.

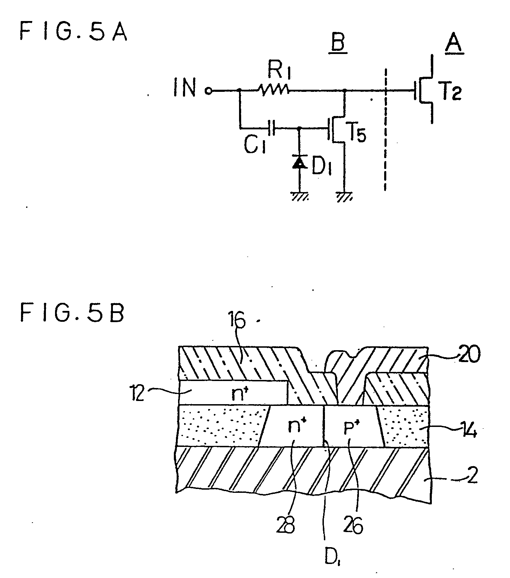

Figures 5A and 5B illustrate essential parts of another embodiment of the present invention.

In this embodiment, resistor R2 of Figure 4A is replaced by a diode D1. As shown in Figure 5B, a $p^+$-type region 26 is grounded via wiring 20 (see Figure 4C) and an $n^+$-type region 28 is connected to an end portion of $n^+$-type polycrystalline silicon layer which makes up the gate electrode of transistor T5. This diode D1 leaks to a considerable extent, so that the gate of transistor T5 is maintained at ground potential in a stationary state, and transistor T5 remains OFF. Operations similar to those seen in the embodiment of Figures 4A to 4C are thus carried out.

As has been described so far, source and drain regions are formed in a self-alignment fashion using polycrystalline silicon as a mask. That is, a layer of polycrystalline silicon is patterned, then implantation of impurity ions is effected. If the polycrystalline silicon layer is floating, charges may be stored in the floating region so formed and the operation of the transistor rendered unstable. This is why the polycrystalline silicon layer is grounded via resistor R2 of high resistance. If a high voltage such as that generated by an electrostatic discharge happens to be applied to the input terminal, transistor T5 turns ON and protection is provided. Thus, without additional processes or additional mask, a transistor having the equivalent of a thick oxide layer can be provided in an embodiment of the present invention. Further, in an embodiment of the present invention, a circuit protecting an internal circuit of a silicon gate MOS IC can be fabricated simultaneously with the fabrication of the internal circuit and without changing the processes necessary for such fabrication. Thus, semiconductor integrated circuit devices embodying the present invention are provided with protective circuits for guarding insulated gate type transistors at inputs to internal circuits of the devices against high voltages applied accidentally to the input terminals, and such a protective circuit can be provided in a silicon-on-sapphire (SOS) structure in which desired circuit elements are fabricated in a silicon island on an insulating substrate.

Thus, in an embodiment of the present invention, for the protection of an internal circuit of a semiconductor integrated circuit device against an excessively high voltage, there is provided a first resistor of a low value interposed between an input terminal and an input gate of the internal circuit, an MIS type transistor of which the drain or the source is connected to the input gate of the internal circuit to be protected, the source or the drain being grounded, a capacitor interposed between the gate of the MIS transistor and the input terminal, and a second resistor or a reverse biased diode which is interposed between the gate of the MIS transistor and ground. Such a protected circuit may be fabricated using a bulk silicon substrate, an insulating substrate such as sapphire or spinel, or a semi-insulating material substrate, simultaneously with fabrication of an internal circuit and without changing processes for fabrication of the internal circuit, without requiring additional masking steps.

**Claims**

1. A semiconductor integrated circuit device, having an element to be protected, wherein the device comprises a first resistive element interposed between an input terminal and the element to be protected, an insulated gate type transistor of which one of the drain and source regions is connected to the element to be protected, and the other of the drain and source regions is connected to a ground line (a line which is grounded when the device is in use), a capacitor interposed between the gate electrode of the insulated gate type transistor and the input terminal, and a second resistive element interposed between the gate of the insulated gate type transistor and a ground line.

2. A device as claimed in claim 1, wherein the element to be protected is an element of an internal circuit of the device, and the said insulated gate type transistor is fabricated in the same manner as transistors of the internal circuit.

3. A device as claimed in claim 1 or 2, wherein the insulated gate type transistor is an MIS type transistor.

4. A device as claimed in claim 1, 2 or 3, wherein the second resistive element is a resistor or a reverse biased diode.

5. A device as claimed in any preceding claim, wherein the element to be protected is an insulated gate type transistor.

6. A device as claimed in any preceding claim, having an SOS structure.

7. A device as claimed in claim 3, or any of claims 4 to 6 read as appended to claim 3, wherein the MIS transistor is a "stacked gate" type transistor comprising a silicon island, source and drain regions, a silicon gate with a gate insulating layer of silicon dioxide and an aluminium electrode, overlying the silicon gate and insulated therefrom by a layer of phospho-silicate glass.

8. A device as claimed in any preceding claim, wherein the first resistive element has a low resistance of the order of 1 k$\Omega$ and the second resistive element has a high resistance of the order of 1 m$\Omega$.

9. A device as claimed in claim 3, or 7, or any of claims 4 to 6 and 8 read as appended to claim 3, wherein the MIS transistor is an N-channel silicon gate MOS transistor.

10. A semiconductor integrated circuit device having an internal circuit and a protective circuit for protecting an element of the internal circuit, against high voltage, wherein a transistor of the protective circuit is an insulated gate type transistor, the gate of which is grounded through a resistor or a reverse biased diode, with a metal electrode provided on the gate and capacitively coupled therewith via an insulation layer, the metal electrode being arranged to receive an input signal, with one of the source and drain regions of the transistor being grounded, and the other of the source and drain regions being arranged to receive the input signal through a further resistor, the element to be protected being arranged to receive the input signal through the said further resistor.

**Patentansprüche**

1. Integrierte Halbleiter-Schaltungsvorrichtung mit einem zu schützenden Element, welche ein erstes Widerstandselement umfaßt, welches zwischen einem Eingangsanschluß und dem zu schützenden Element angeordnet ist, und einen Transistor mit isolierter Gateelektrode, dessen Drainbereich oder Sourcebereich mit dem zu schützenden Element verbunden und dessen anderer Sourcebereich bzw. Drainbereich mit einer Erdleitung verbunden ist (einer Leitung welche während des Betriebs der Vorrichtung geerdet ist), und einen Kondensator, welcher zwischen der Gateelektrode des Transistors und dem Eingangsanschluß angeordnet ist, und ein zweites Widerstandselement, welches zwischen der Gateelektrode des Transistors mit isolierter Gateelektrode und einer Erdleitung angeordnet ist.

2. Vorrichtung nach Anspruch 1, bei welcher das zu schützende Element ein Element einer internen Schaltung der Vorrichtung ist und der genannte Isolierschicht-Transistor in gleicher Weise wie die Transistoren der internen Schaltung hergestellt ist.

3. Vorrichtung nach Anspruch 1 oder 2, bei welcher der Isolierschicht-Transistor ein MIS-Transistor ist.

4. Vorrichtung nach einem der Ansprüche 1, 2 oder 3, bei welcher das zweite Widerstandselement ein Widerstand oder eine in Sperrichtung gepolte Diode ist.

5. Vorrichtung nach einem der vorhergehenden Ansprüche, bei welcher das zu schützende Element ein Isolierschicht-Transistor ist.

6. Vorrichtung nach einem der vorhergehende Ansprüche mit einer SOS-Struktur.

7. Vorrichtung nach Anspruch 3 oder einem der Ansprüche 4 bis 6 in Verbindung mit Anspruch 3, bei welcher der MIS-Transistor ein Transistor mit "geschichteter Gateelektrode" ist, welcher eine Siliziuminsel, Source- und Drainbereiche, eine Siliziumgateelektrode mit einer Gateisolierungsschicht aus Siliziumdioxid und eine Aluminiumelektrode umfaßt, welche über der Siliziumgateelektrode liegt und von dieser durch eine Schicht aus Phosphorsilikat isoliert ist.

8. Vorrichtung nach einem der vorhergehenden Ansprüche, bei welcher das erste Widerstandselement einen niedrigen Widerstandswert in der Größenordnung von 1 k Ohm und das zweite Widerstandselement einen hohen Widerstand in der Größenordnung von 1 M Ohm hat.

9. Vorrichtung nach einem der Ansprüche 3 oder 7 oder nach einem der Ansprüche 4 bis 6 und 8 in Verbindung mit Anspruch 3, bei welcher der MIS-Transistor ein MOS-Transistor mit einem N-Kanal und einer Siliziumgateelektrode ist.

10. Integrierte Halbleiter-Schaltungsvorrichtung mit einer internen Schaltung und einer Schutzschaltung zum Schutz eines Elements der internen Schaltung, bei welcher ein Transistor der Schutzschaltung ein Transistor mit isolierter Gateelektrode ist, dessen Gateelektrode über einen Widerstand oder eine in Sperrichtung gepolte Diode geerdet ist, mit einer Metallelektrode, welche über eine Isolierschicht auf der Gateelektrode vergesehen und kapazitiv mit ihr gekoppelt ist, wobei die Metallelektrode so angeordnet ist, daß sie ein Eingangssignal empfängt, und bei welcher entweder der Source- oder der Drainbereich des Transistors geerdet ist und der andere Drainbereich bzw. Sourcebereich so angeordnet ist, daß er über einen weiteren Widerstand das Eingangssignal erhält, und bei welcher das zu schützende Element so angeordnet ist, daß es über den genannten weiteren Widerstand das Eingangssignal erhält.

## Revendications

1. Un dispositif à circuit intégré semiconducteur ayant un élément à protéger, ce dispositif comprenant un premier élément résistif intercalé entre une borne d'entrée et l'élément à protéger, un transistor du type à grille isolée dont l'une des régions de drain et de source est connectée à l'élément à protéger, et dont l'autre région parmi les régions de drain et de source est connectée à une ligne de masse (une ligne qui est reliée à la masse lorsque le dispositif est utilisé), un condensateur intercalé entre l'électrode de grille du transistor du type à grille isolée et la borne d'entrée, et un second élément résistif intercalé entre la grille du transistor du type à grille isolée et une ligne de masse.

2. Un dispositif selon la revendication 1, dans lequel l'élément à protéger est un élément d'un circuit interne du dispositif, et le transistor du type à grille isolée est fabriqué de la même manière que les transistors du circuit interne.

3. Un dispositif selon la revendication 1 ou 2, dans lequel le transistor du type à grille isolée est un transistor du type MIS.

4. Un dispositif selon la revendication 1, 2 ou 3, dans lequel le second élément résistif est une résistance ou une diode polarisée en inverse.

5. Un dispositif selon n'importe quelle revendication précédente, dans lequel l'élément à protéger est un transistor du type à grille isolée.

6. Un dispositif selon n'importe quelle revendication précédente, ayant une structure silicium sur saphir (SOS).

7. Un dispositif selon la revendication 3, ou l'une quelconque des revendications 4 à 6 considérée comme dépendante de la revendication 3, dans lequel le transistor MIS est un transistor du type à "grille empilée" comprenant un îlot de silicium, des régions de source et de drain, une grille en silicium avec une couche d'isolation de grille en dioxyde de silicium, et une électrode en aluminium recouvrant la grille en silicium et isolée de cette dernière par une couche de verre au phosphosilicate.

8. Un dispositif selon n'importe quelle revendication précédente, dans lequel le premier élément résistif a une résistance faible, de l'ordre de 1 kΩ et le second élément résistif a une résistance élevée, de l'ordre de 1 MΩ.

9. Un dispositif selon la revendication 3 ou 7, ou l'une quelconque des revendications 4 à 6 et 8 considérée comme dépendante de la revendication 3, dans lequel le transistor MIS est un transistor MOS à grille isolée et à canal N.

10. Un dispositif à circuit intégré à semiconducteur ayant un circuit interne et un circuit protecteur destiné à protéger un élément du circuit interne contre une tension élevée, dans lequel un transistor du circuit protecteur est un transistor du type à grille isolée, dont la grille est reliée à la masse par une résistance ou une diode polarisée en inverse, avec une électrode en métal établie sur la grille et en couplage capacitif avec cette dernière par l'intermédiaire d'une couche d'isolation, l'électrode en métal étant prévue du façon à recevoir un signal d'entrée, avec l'une des régions de source et de drain du transistor reliée à la masse, et l'autre région parmi les régions de source et de drain prévue pour recevoir le signal d'entrée par l'intermédiaire d'une résistance supplémentaire, l'élément à protéger recevant le signal d'entrée par ladite résistance supplémentaire.

FIG.1

FIG.2

FIG.3

FIG.4A

FIG.4B

FIG.4C

FIG.5A

IN ——[R₁]—— $\underline{B}$ ——— $\underline{A}$ T2

C₁ T5

D₁

FIG.5B

16

12

20

n⁺

n⁺ P⁺

14

2

28 26

D₁